Europäisches Patentamt

European Patent Office

Office européen des brevets

(11) Veröffentlichungsnummer: **0 141 278**
**A2**

(12) ## EUROPÄISCHE PATENTANMELDUNG

(21) Anmeldenummer: **84111808.6**

(22) Anmeldetag: **03.10.84**

(51) Int. Cl.⁴: **H 05 K 13/02**
**H 05 K 13/04**

(30) Priorität: **10.10.83 DE 3336767**

(43) Veröffentlichungstag der Anmeldung:
**15.05.85 Patentblatt 85/20**

(84) Benannte Vertragsstaaten:
**AT BE CH DE FR GB IT LI LU NL SE**

(71) Anmelder: **Lemmer, Alfred**
**Machtlfingerstrasse 24**
**D-8000 München 70(DE)**

(72) Erfinder: **Lemmer, Alfred**
**Machtlfingerstrasse 24**
**D-8000 München 70(DE)**

(74) Vertreter: **Schmidt-Evers, Jürgen, Dipl.-Ing. et al,**
**Patentanwälte Dipl.-Ing. H. Mitscherlich Dipl.-Ing. K.**
**Gunschmann Dipl.-Ing. Dr.rer.nat. W. Körber Dipl.-Ing. J.**
**Schmidt-Evers Dipl.-Ing. W. Melzer Steinsdorfstrasse 10**
**D-8000 München 22(DE)**

(54) **Vorrichtung zum Übertragen von elektronischen Bauelementen, insbesondere IC's.**

(57) Die Erfindung bezieht sich auf eine Vorrichtung zur Übertragung elektronischer Bauelemente, insbesondere IC's von einem Depot zu einem Verwertungsort, wobei die Bauelemente in einer Entnahmeöffnung bereit gestellt und mittels eines Greifkopfs ergriffen werden, und verfolgt den Zweck, die Entnahmeöffnung zur Entnahme von in Form bzw. Größe unterschiedliche Bauelemente einzurichten. Dies wird dadurch erreicht, daß der Entnahmeöffnung ein, das zu entnehmende Bauelement übergreifendes Halteteil, zugeordnet ist, das in Entnahmerichtung elastisch auslenkbar ist.

EP 0 141 278 A2

./...

FIG. 2

Vorrichtung zum Übertragen von elektronischen Bauelementen, insbesondere IC's

----------------------------------------------------

Die Erfindung bezieht sich auf eine Vorrichtung nach dem Oberbegriff des Anspruches 1.

EineVorrichtung dieser Bauart ist in der DE-OS 28 46 262 beschrieben und dargestellt. Bei dieser bekannten Vorrichtung werden die Bauelemente insbesondere IC's, in einem Depot gespeichert und an einer Entnahmeöffnung bereitgestellt, an der sie mittels eines Greifkopfs entnehmbar und zum gewünschten Verwendungsort bewegbar sind.

Der bekannte Bestückungstisch hat sich als praktisch und brauchbar erwiesen. Angesichts der Vielzahl von sich in Art und Größe unterscheidenden Bauelementen, z.B. IC's unterschiedlicher Länge, besteht die Forderung nach einer Flexibilität für das Depot. Um an ein und derselben Entnahmestelle unterschiedliche Bauelemente zu entnehmen, bedarf es bei der bekannten Vorrichtung einer Umrüstung bzw. eines Austausches wenigstens der Entnahmeöffnung, wodurch erhebliche Rüstzeiten vorgegeben sind.

Der Erfindung liegt die Aufgabe zugrunde, eine Vorrichtung der vorliegenden Bauart so auszubilden, daß unterschiedlich große Bauelemente, insbesondere IC's, ohne eine Umrüstung der Entnahmeöffnung entnommen werden können.

Diese Aufgabe wird durch eine Ausgestaltung nach dem Kennzeichen des Anspruches 1 gelöst. Bei einer erfindungsgemäß ausgestalteten Vorrichtung bedarf es keiner Umrüstung der Entnahmeöffnung, wenn ein Bauelement unterschiedlicher Größe entnommen werden soll, weil die Größe der Entnahmeöffnung in beiden Dimensionen variabel ist. Da das das Bauelement in der Entnahmeöffnung gegen Herausfallen sichernde Halteteil bei der Entnahme des Bauelements elastisch auslenkt, erfolgt sozusagen eine automatische und stufenlose Anpassung der erforderlichen Entnahmeöffnungsgröße an das betreffende Bauelement. Dabei ist es möglich, eine beträchtlich große Größenstufung mit ein und derselben Entnahmeöffnung zu umfassen, was davon abhängig ist, wie groß das Maß der Übergreifung ausgelegt werden kann, mit dem das Halteteil das Bauelement übergreift bzw. diesem vorgreift. Der durch die Erfindung erzielbare Vorteil zeigt sich bei der Verarbeitung von IC's besonders deutlich. Diese unterscheiden sich hauptsächlich lediglich durch ihre Länge, wobei ihre Querschnittsabmessungen bzw. -konturen gleich sind. Solche unterschiedlichen IC's können deshalb in ein und demselben Depot bereitgestellt werden, weil sie sich in den der Führung zur Entnahmeöffnung dienenden Abmessungen nicht voneinander unterscheiden. Eine erfindungsgemäße Ausgestaltung ermöglicht es, solche unterschiedlichen IC's durch ein und dieselbe Entnahmeöffnung zu führen, ohne das Umrüstarbeiten verrichtet werden müssen.

Natürlich ist es auch möglich, andere Bauelemente unterschiedlicher Größe bzw. Art durch ein und dieselbe Entnahmeöffnung zu führen, wenn bestimmte Führungskonturen bzw. -abmessungen dieser Bauelemente gleich sind.

Die Entnahmeöffnung ist deshalb in beiden Dimensionen variabel, weil es zur Sicherung eines Bauelementes in der Entnahmeöffnung ausreicht, das Bauelement von einer Seite her teilweise zu übergreifen. Die Entnahmeöffnung kann deshalb in der anderen Dimension erheblich größer ausgebildet sein, wodurch sie (natürlich) auch in dieser Dimension für den Durchgang von unterschiedlich großen Bauelementen geeignet ist. Im Rahmen der Erfindung ist es jedoch auch denkbar, eine Entnahmeöffnung mit zwei Halteteilen zu versehen, die an z.B. rechtwinklig zueinander verlaufenden Seiten angeordnet sind.

Es ist zu beachten, daß das Maß, mit dem das Halteteil das Bauelement in seine Umfangsrichtung oder quer übergreift, nicht größer ist als das doppelte Maß in der gleichen Dimension des kleinsten, zu berücksichtigenden Bauelements, da andernfalls das oberhalb oder neben dem zu entnehmenden Bauelement befindliche Bauelement in der Entnahmeöffnung nicht gegen Herausfallen gesichert ist. Dabei wird vorausgesetzt, daß die Entnahmeöffnung auch nicht größer bemessen ist, als das doppelte Maß des kleinsten, zu berücksichtigenden Bauelements, um das oberhalb oder neben dem zu entnehmenden Bauelement liegende Bauelemente durch die Entnahmeöffnungsbegrenzungskante zu sichern.

Bei einer Ausgestaltung nach Anspruch 2 ist das Bauelement in seiner Bereitschaftsstellung zur Entnahme von beiden Seiten gesichert.

Die Ausbildung nach Anspruch 3 umfaßt eine einfache und deshalb vorteilhafte Ausführungsform für Halteteile, die in diesem Falle durch einfache plattenförmige Lamellen gebildet sind, die an ihrer der Entnahmeöffnung abgewandten Seite gehalten sind.

Gemäß den Ansprüchen 4 und 6 sind - längs einer Seite der Entnahmeöffnung gesehen - mehrere Halteteile hintereinander angeordnet, wodurch es möglich ist, Bauelemente eines großen Stufungsbereiches und mit verhältnismäßig kleinen Stufensprüngen, d.h. verhältnismäßig kleinen Unterschieden von Baugröße zu Baugröße, in der Bereitschaftsstellung zur Entnahme sicher zu halten. Hierbei ist die Abmessung der Entnahmeöffnung durch die Anzahl der hintereinander angeordneten Halteteile und durch die Abstände, die gegebenenfalls zwischen den Halteteilen vorgesehen sind, bestimmt.

Dabei ist es gemäß Anspruch 5 empfehlenswert, wenigstens die Halteteile einer Seite der Entnahmeöffnung gleich auszubilden, um so wenig wie möglich sich voneinander unterscheidende Bauteile zu erhalten.

Bei einer Ausgestaltung nach Anspruch 7 wird das Halteteil durch einen in sich steifen Hebelarm gebildet, der durch eine Feder in Richtung auf seine Normalstellung beaufschlagt ist, d.h. in die Stellung, in der er das Bauelement in seiner Bereitschaftsstellung sichert.

Bei dieser Ausführungsform ist es aus Herstellungs- und Montagegründen zweckmäßig, gemäß Anspruch 8 die erforderliche Schwenkachse so lang auszubilden, daß sie alle Halteteile einer Entnahmeöffnungsseite zu durchfassen vermag.

Die Ausbildung nach Anspruch 9 ist aus Platzgründen vorteilhaft, weil die das Zurückstellen der Halteteile bewirkende Feder deshalb besser an dem der Entnahmeöffnung abgewandten Hebelarm anzubringen ist, weil sich auf der Seite des ersten Hebelarmes die Entnahmeöffnung befindet.

Bei der Anordnung von zwei gegenüberliegenden Halteteilen empfiehlt sich die Ausgestaltung nach Anspruch 1o ebenfalls aus Herstellungskosten und Montagegründen, wobei eine blattförmige Feder deshalb vorteilhaft ist, weil sie längs ihrer Breitseite eine gewisse Biegesteifigkeit aufweist und deshalb einfacher anzuordnen ist.

Bei der Entnahme eines Bauelementes aus der Entnahmeöffnung werden die Halteteile um einen bestimmten Schwenkwinkel ausgeschwenkt, wobei sie um ein gewisses Maß in Entnahmerichtung vortreten. Dieses Maß läßt sich durch eine Ausgestaltung gemäß Anspruch 11 verringern, weil die Schwenkachse entgegen der Entnahmerichtung versetzt ist. Ein allzu weites Hervortreten der Halteteile ist unerwünscht, weil bei der Bemessung des Hubes des für die Entnahme des Bauelementes aus der Entnahmeöffnung vorgesehenen Greifkopfes dieses Maß zu berücksichtigen ist.

Um auch unterschiedliche Bauelemente sicher in ihrer Entnahmebereitschaftsstellung zu halten, empfiehlt es sich gemäß Anspruch 12, verstellbare Anschläge für die Halteteile vorzusehen, um deren Normalstellung an diese Abmessungen der Bauelemente anpassen zu können.

Da damit zu rechnen ist, daß die sich im Bereich der Entnahmeöffnung befindlichen Bauelemente gleich sind und deshalb die Normalstellung für diese Halteteile gleich ist, empfiehlt sich die aus dem Anspruch 13 entnehmbare Ausführungsform.

Es ist damit zu rechnen, daß auch Bauelemente solcher Größen und insbesondere Formunterschiede zu verarbeiten sind, die trotz des Vorliegens einer erfindungsgemäßen Ausgestaltung eine Umrüstung, zumindest der Entnahmeöffnung, erfordern. Es ist deshalb zweckmäßig, gemäß Anspruch 14 die Entnahmeöffnung einem Entnahmeendstück zuzuordnen, das bevorzugt formschlüssig am Depot festlegbar ist. Dabei eignet sich insbesondere ein Entnahmeendstück, das schnell und einfach aufklipsbar ist, so daß das Depot schnell und einfach umgerüstet werden kann. Der an das Entnahmeendstück anschließende Zuführungskanal kann dann in einer geeigneten Weise am Depot festgelegt werden.

Die Ausbildung nach Anspruch 16 ist insbesondere im Hinblick auf den vorgenannten Anschluß eines Zuführungskanals von Vorteil. Da der Zuführungskanal in das Entnahmeendstück übergeht, ist verständlich, daß das Entnahmeendstück an dem dem Zuführungskanal zugewandten Ende unter Vermeidung von quer zur Zuführungsrichtung gerichteten Bewegungen in dem Formschluß einführbar sein sollte. Im Anspruch 17 ist eine praktischere Ausführungsform für eine Formschlußverbindung gemäß Anspruch 16 beschrieben.

Durch eine Ausbildung gemäß Anspruch 18 ist nicht nur eine sichere Führung gewährleistet, sondern der hier beschriebene Führungssteg stellt sich in noch zu beschreibender Weise als praktisches Stützelement für das betreffende Bauelement bei dessen Ergreifung durch den Greifkopf dar.

Die Begrenzung des Zuführungskanals, durch den die Bauelemente zur Entnahmeöffnung gelangen, erfolgt gemäß Anspruch 19 durch ein Wandteil eines Bodenstücks, das mittelbar oder unmittelbar starr am Depot befestigt sein und somit eine Auflage für das Entnahmeendstück bilden kann.

Gemäß Anspruch 2o und 21 ist das Bodenstück in die im Anspruch 15 angeführte Klipsverbindung einbezogen. Dies ist aus Platz- und gemäß Anspruch 21 insbesondere aus Bedienungsgründen von Vorteil. Beim Lösen der im Sinne des Anspruches 21 ausgestalteten Verrastung bedarf es lediglich eines leicht und bequem auszuübenden manuellen Druckes auf die Griffstücke.

Zu einem erleichterten Ausbau des Entnahmeendstückes führt auch die Ausgestaltung nach Anspruch 22. Da eine solche beim Lösen der Rastverbindung automatisch zu einem Abheben des Entnahmeendstückes führt, kann das Entnahmeendstück leicht und einfach durch eine Hand entfernt werden.

Die Entnahme eines Bauelementes aus der Entnahmeöffnung ist deshalb recht schwierig, weil es sich bei den Bauelementen um empfindliche Teile handelt, die leicht zerstört werden können. Zur Handhabung von IC's ist es durch den eingangs genannten Stand der Technik schon bekannt, eine Greifzange zu benutzen, die den Steg des betreffenden IC's breitseits neben den Anschlußfahnen ergreift. Dies ist zwar eine brauchbare Lösung, jedoch besteht zum einen die Gefahr, daß beim Greifen Anschlußfahnen des IC's verbogen werden und zum anderen wird das Ergreifen an dieser Stelle problematisch, wenn unterschiedlich breite IC's (unterschiedlich breite Stege) mit ein und derselben Greiferzange zu erfassen sind. Demgegenüber ist gemäß Anspruch 23 ein Greifkopf vorgesehen, bei der die Innenseite des Steges von einem Greiferfinger hinterfaßt wird. D.h. der Steg des IC's wird quer zu seiner Breite erfaßt, so daß eine Breitenveränderung nicht störend in Erscheinung tritt.

Die durch eine Ausgestaltung im Sinne des Anspruches 23 erzielbaren Vorteile sind auch dann erreichbar, wenn die Entnahmeöffnung nicht im Sinne der vorliegenden Erfindung ausgeführt ist. Dem Anspruch 23 kommt somit eine selbständige erfinderische Bedeutung zu.

Bei einer Ausgestaltung im Sinne der Ansprüche 24 und 25 wird das ergriffene Bauelement entgegen der Entnahmerichtung zunächst gegen den Führungssteg gemäß Anspruch 18 und beim Zurückziehen des Greifkopfes gegen den Schenkel des Greiferfingers gedrückt. Infolgedessen wird das zu entnehmende Bauelement nicht nur sicher ergriffen, was insbesondere für ein IC gilt. Dabei wird die innere Stegseite des IC's zur Bezugsfläche für das Ergreifen.

Der schmale stirnseitige Steg gemäß Anspruch 26 gewährleistet ebenfalls ein sicheres Ergreifen wobei die seitlichen Halteteile unbeeinträchtigt bleiben.

Der Anspruch 27 bezieht sich auf eine einfache und vorteilhafte Ausführungsform, um den Steg des Greiferfingers hinter das zu ergreifende Bauelement zu setzen. Bei einer schwenkbaren Lagerung des Greiferfingers liegt eine sichere Führung vor, ohne daß es

0141278

besonderer Führungsmaßnahmen bedarf, die zum Bei- spiel bei einer Parallelverstellung notwendig wären.

In der ergriffenen Position wird die von dem Spannbolzen auf das Bauelement übertragene Spannkraft von dem Greiferfinger voll aufgenommen. Es ist deshalb die aus Anspruch 28 entnehmbare Ausbildung vorteilhaft, um sicher zu stellen, daß die Spannkraft gleichmäßig auf den Schenkel übertragen wird.

Insbesondere bei einer Ausgestaltung gemäß Anspruch 29 bei der der Greiferfinger durch eine Feder in seine Offenstellung beaufschlagt ist, ist die Ausgestaltung nach Anspruch 28 zu empfehlen, weil in diesem Falle eine geringere Vorspannkraft ausreicht, um die gleich- zeitig am Greiferfinger wirksame Schwenkkraft durch Reibungsschluß auszuschalten.

Das Hintersetzen des Greiferfingers kann in einfacher Weise gemäß Anspruch 3o erfolgen, wobei von Bedeutung ist, saß jener Stößel nicht Teil des Greifkopfes zu sein braucht, diesersomit einfacher herzustellen ist. Der Stößel kann nämlich in einer geeigneten Führung eines unabhängigen Bauteiles geführt sein.

Die Ausbildung nach Anspruch 31 umfaßt einen einfachen Antrieb für den Stößel, wobei zu berücksichtigen ist, daß die erforderliche Kraft nicht groß ist und von einem Elektromagneten gut aufgebracht werden kann.

Beim eingangs beschriebenen Stand der Technik wird das aus der Entnahmeöffnung entnommene Bauelement samt dem Greifkopf durch eine Übertragungsvorrichtung zum Verwertungsort übertragen, wo das Bauelement mit Hilfe des Greifkopfes dem jeweiligen Verwertungszweck entsprechend bereitgestellt wird. Die bekannte

Übertragungsvorrichtung hat sich in der Praxis als kompliziert und schwierig steuerbar erwiesen, was insbesondere für das Drehen um die parallel zur Basis verlaufende Achse gilt. Demgegenüber ist die im Anspruch 32 vorgeschlagene Übertragungsvorrichtung durch eine einfache Bauform, sichere Funktion sowie gute Steuerbarkeit gekennzeichnet. Außerdem ist es gelungen, nur einen Motorantrieb sowohl für die vorgenannte Drehbewegung als auch für die parallel zur Basis gerichtete Schwenkbewegung der Übertragungsvorrichtung auszunutzen. Dabei erfolgt die Schwenkbewegung und die Drehbewegung in Richtung auf die Entnahmeöffnung zwangsläufig. Die der letzteren entgegengesetzte Bewegung wird durch eine Feder erzeugt, die die beweglichen Getriebeteile der Kurvenbahn nachführt.

Die Kurvenbahn wird gemäß Anspruch 33 an einer Exzenterscheibe ausgebildet, die an der Drehbwegung der Antriebswelle nicht teilnimmt und zu deren Lagerung dienen kann.

Es empfiehlt sich gemäß Anspruch 34, die Kurvenbahn mittels eines Rades abzugreifen, wodurch Reibungsverluste und Verschleiß niedrig gehalten werden können.

Der Ausleger, an dem die Führungen bzw. Lagerungen für die Zahnstange ausgebildet und das Zahnrad gelagert sind, läßt sich hierzu vorteilhaft durch zwei Platten bilden, die im Sinne des Anspruches 35 angeordnet und befestigt sind.

Der in Richtung auf das Depot und zurück verschiebbare Greifkopf ist nach Anspruch 36 in zwei Säulenführungen verschiebbar, wodurch eine gute Führung gewährleistet ist, bei der auch Bewegungen des Greifkopfes um seine Längsachse sicher ausgeschaltet sind.

Im Anspruch 37 ist die Halterung der Führungssäulen in einem U-förmigen Schlittenhalter beschrieben. Diese Ausführungsform läß sich vorteilhaft in die vorgegebenen Baukörper integrieren.

Der Antrieb der Übertragungsvorrichtung kann durch ein auf der Antriebswelle befestigtes Antriebsrad erfolgen, das durch einen Zahnriementrieb abtreibbar ist. Durch einen Zahnriementrieb ist Antriebsschlupf ausgeschlossen. Dies ist wichtig, weil durch die begrenzten Bewegungen der Übertragungsvorrichtung entstehende Schwungkräfte aufgebracht bzw. gebremst werden müssen.

Beim eingangs genannten Stand der Technik sind für die Bestückung unterschiedlicher Bauelemente mehrere Magazine am Depot vorgesehen, das eine um eine vertikale Achse drehbare und angetriebene Scheide umfaßt, auf deren Umfang die Magazine festgelegt sind. Angesichts einer notwendigen Baugröße für die Magazine ist ihre Anzahl bei einer vertretbaren Scheibengröße begrenzt. Für den Fall, daß eine Vielzahl von Magazinen am Depot anzubringen sind, wird gemäß Anspruch 39 vorgeschlagen, die Anbringungsfläche für die Magazine durch ein Band oder durch eine Kette zu bilden, das sowohl die Antriebsscheibe als auch eine weitere Scheibe umspannt. Hierdurch kann die Anzahl der Magazinplätze um ein Vielfaches vergrößert werden, wobei gegebenenfalls gleichzeitig die Größe der Antriebsscheibe verringert werden kann. Von Bedeutung ist, daß eine formschlüssige Antriebsverbindung zwischen der antreibbaren Drehscheibe und dem Band oder der Kette besteht, damit auch hier aufgrund der auftretenden Schwungkräfte keine Relativbewegung zwischen der antreibbaren Dreh-

0141278

scheibe und dem Band bzw. der Kette erfolgt. Eine solche Relativbewegung würde die jeweiligen Entnahmepositionen der Magazine verändern, was natürlich unerwünscht ist.

Eine erfindungsgemäß ausgestaltete Vorrichtung läßt sich vorteilhaft für einen Bestückungstisch nach Anspruch 4o verwenden, weil sie zum einen wegen ihrer Funktion und Bauform bzw. -größe und zum anderen wegen ihrer Anpaßbarkeit an Bauelemente unterschiedlicher Form und Größe den bei solchen Bestückungstischen vorliegenden Forderungen gerecht wird.

Die Ausgestaltungen nach den Ansprüchen 41 bis 47 sind insbesondere in den Fällen vorteilhaft einzusetzen, in denen das Depot mit Magazinen zu bestücken ist, die zwecks Zuführung unterschiedlicher Bauelemente am Depot neu anzusetzen oder auszutauschen sind, was im Hinblick auf Stillstandzeiten schnell und einfach erfolgen soll. Die erfindungsgemäßen Ausgestaltungen erfüllen diese Forderung und führen darüberhinaus zu einer sicheren Halterung der Magazine. Durch die Ausbildungen nach den Ansprüchen 46 und 47 wird nicht nur Material für den Kopf und Gewicht gespart, sondern auch ein elastischer Sitz im Adapter, obwohl die Passung keiner Präzision bedarf. Gemäß Anspruch 47 erfolgt darüberhinaus eine Abstützung des Kopfes an alle vier Wände des Adapters, wobei die Spannungsrichtung der Halterungsarmpaare zueinander rechtwinklig verlaufen.

Nachfolgend wird ein Ausführungsbeispiel der Erfindung anhand einer vereinfachten Zeichnung näher beschrieben.

Es zeigen:

Fig. 1 einen Bestückungstisch in der Draufsicht,

Fig. 2 eine perspektivische Darstellung des Teilbereichs des Magazins, in dem die Entnahmeöffnung für die im Magazin bespeicherten Bauelemente vorgesehen ist,

Fig. 3 einen Schnitt nach der Linie III-III in Fig. 2,

Fig. 4 die in der Fig. 3 mit X gekennzeichnete Einzelheit in der Seitenansicht,

Fig. 5 einen lotrechten Schnitt durch einen Teilbereich des Magazins nach der Linie V-V in Fig. 2,

Fig. 6 eine perspektivische Darstellung des Magazinendes,

Fig. 7 einen lotrechten Schnitt durch die Entnahmeöffnung mit einer sich in Greifstellung befindlichen Greifeinrichtung für die zu entnehmenden Bauelemente.

Fig. 8 die Greifeinrichtung in Verbindung mit einer Übertragungsvorrichtung, teilweise geschnitten,

Fig. 9 die Greifeinrichtung mit der Übertragungsvorrichtung in der Abgabebereitschaftsstellung,

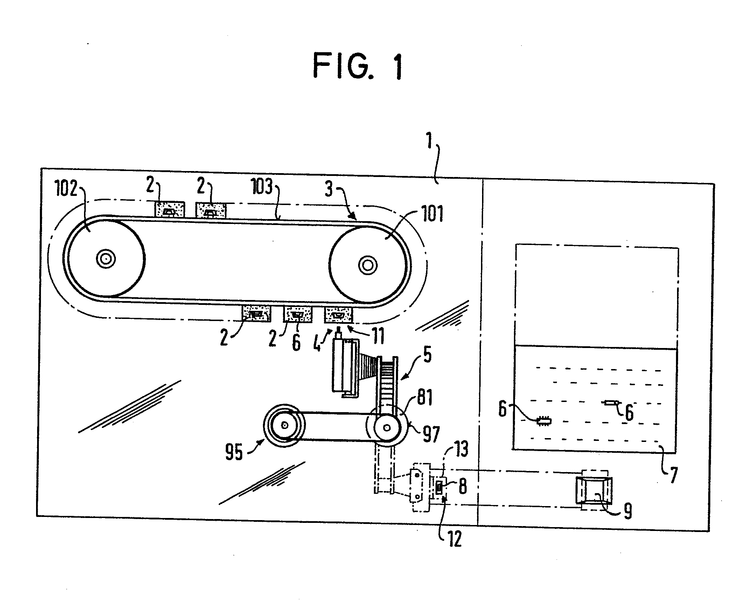

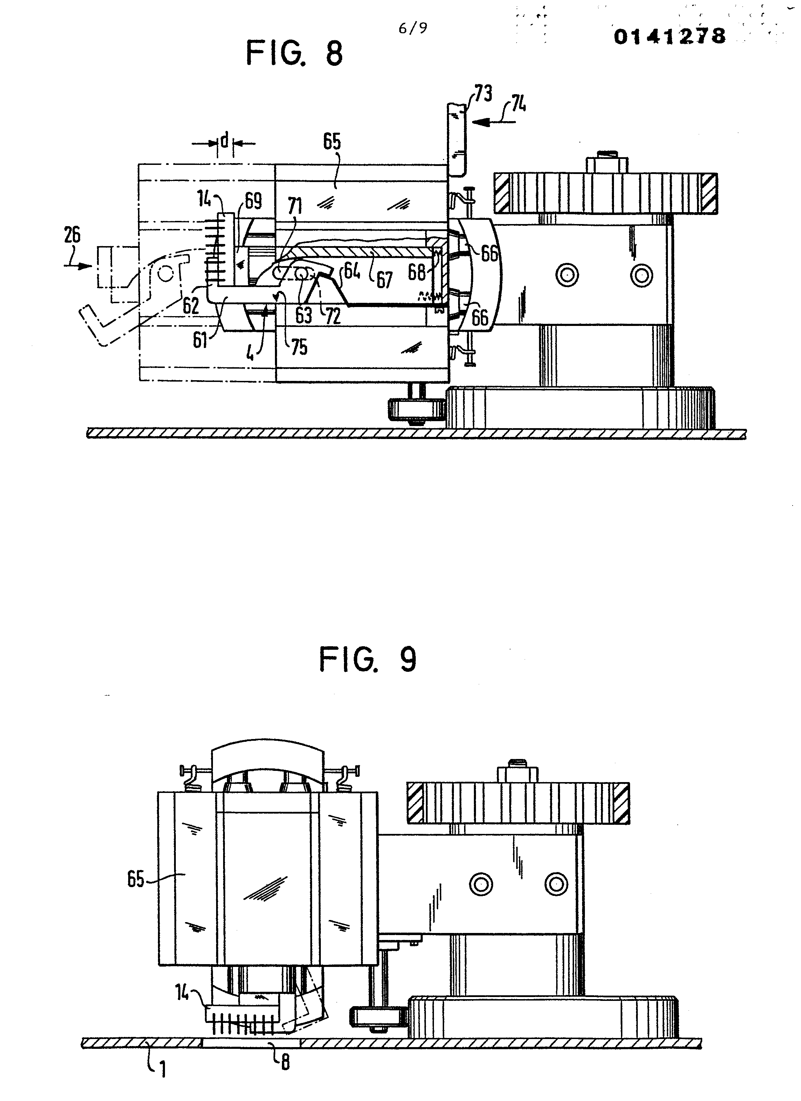

Fig.1o die Greifeinrichtung mit der Übertragungsvorrichtung nach Fig. 9 in der Seitenansicht von links.

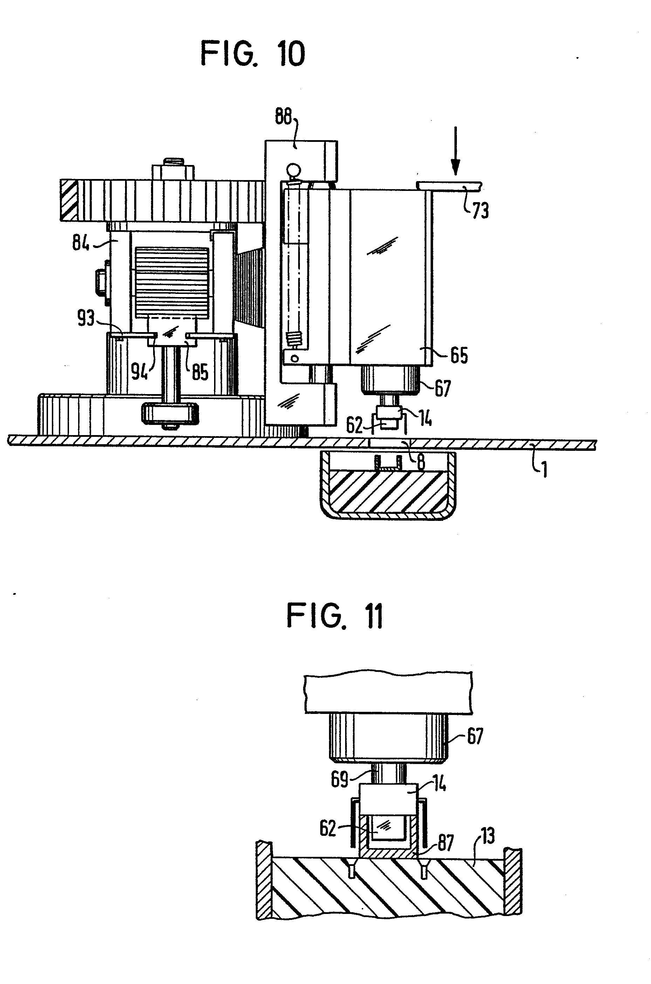

Fig. 11 eine Teilansicht der Greifeinrichtung in ihrer Abgabestellung,

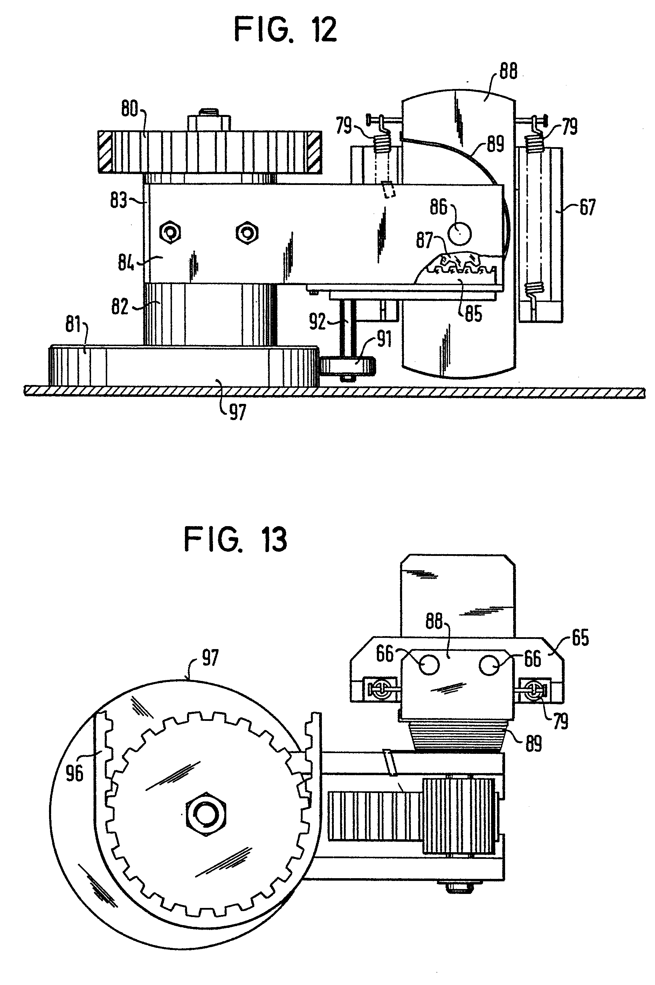

Fig. 12 die Greifeinrichtung mit der Übertragungsvorrichtung gemäß Fig. 9 in der Rückansicht.

Fig. 13 die Greifeinrichtung mit der Übertragungsvorrichtung gemäß Fig. 12 in der Draufsicht und

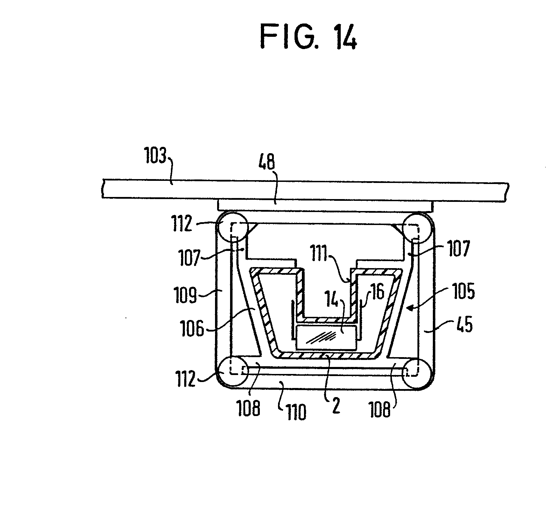

Fig. 14 eine Draufsicht auf einen ein Magazin mit Kopf aufnehmenden Adapter.

Auf dem in Fig. 1 als rechteckige Fläche dargestellten Bestückungstisch 1 befinden sich ein mehrere Magazine 2 umfassendes, allgemein mit 3 bezeichnetes Deopot, eine Greifeinrichtung 4, die einer Übertragungsvorrichtung 5 zugeordnet ist und mit dieser in noch zu beschreibender Weise versetzt werden kann, und eine mit elektronischen Bauelementen 6 zu bestückende Leiterplatte 7. Darüberhinaus weist der Bestückungstisch 1 eine Stecköffnung 8 und eine Grifföffnung 9 auf, deren Zweck folgender ist:

Zum Bestücken der Leiterplatte 7 werden die Bauelemente 6 in den Magazinen 2 bereitgestellt, in denen jeweils Bauelemente 6 einer bestimmten Größe bzw. Form gesammelt sind. Aus diesem Grund umfaßt das Depot 3 mehrere Magazine 2, die z.B. in programmgesteuerter Weise der mit 11 bezeichneten Entnahmestelle für die Bauelemente 6 zugeführt werden.

An der Entnahmestelle 11 werden die Bauelemente 6 von der Greifeinrichtung 4 in noch zu beschreibender Weise ergriffen und mit Hilfe der Übertragungsvorrichtung 5 an einer Abgabestelle 12 durch die Stecköffnung 8 in eine Griffschale 13 gesteckt, die in nicht dargestellter Weise unterhalb der Tischoberseite unter die Grifföffnung 9 transportiert wird. An dieser Stelle entnimmt die am Bestückungstisch 1 arbeitende Person das Bauelement 6 aus der Griffschale 9 und bestückt damit die Leiterplatte 7 an einer gegebenenfalls besonders bezeichneten Stelle.

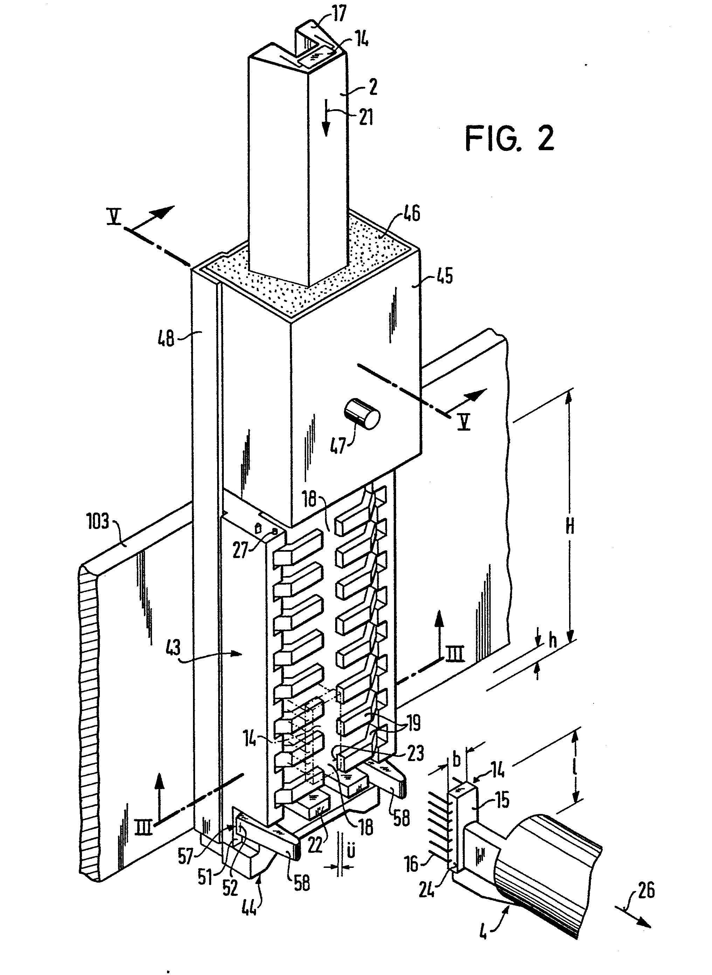

Im folgenden wird die Entnahme eines Bauelements 6 beschrieben, wobei im Magazin 2 ICs 14 enthalten sind. Die ICs bestehen in üblicher Weise aus einem Steg 15, und Anschlußfahnen bzw. Anschlußstiften 16 die insgesamt ein U-förmiges Gebilde ergeben (siehe Figur 2).

Die im Magazin 2 gesammelten ICs 14 gelangen durch einen Führungskanal 17 in den Bereich einer Entnahmeöffnung 18, die durch eine Vielzahl von beidseitig der Entnahmeöffnung 18 und übereinander angeordneter Federhebel 19 mit einer Höhe h verschlossen ist. Der Zuführungskanal 17 ist längs der Zuführungsrichtung 21 durch eine Wand 22 begrenzt, auf der das sich jeweils in Entnahmeposition befindliche, angedeutete IC 14 liegt. In dieser Stellung sichern die Federhebel 19 das IC 14 gegen Herausfallen, wobei die Federhebel 19 mit ihren Übergreifkanten 23 die Seitenkanten 24 des IC 14 übergreifen.

Zur Entnahme des IC 14 aus der Entnahmeöffnung 18 wird die in Figur 2 nur andeutungsweise dargestellte und noch zu beschreibende Greifeinrichtung 4 entgegen der Entnahmerichtung 26 in ihre Greifstellung vorgeschoben, wo sie das IC 14 zu ergreifen vermag, und

16

wieder zurückgeschoben. Dabei schwenken die jeweilig untersten drei Federhebel 19. in Entnahmerichtung 26 aus, so daß das IC herausgeführt werden kann. Danach schnappen die Federhebel 19. durch Federkraft wieder in ihre Normalstellung zurück. Bei der Entnahme des (untersten) IC 14 ist das sich darüberbefindliche nicht dargestellte IC in der Entnahmeöffnung .18 gesichert, weil die sich oberhalb des untersten IC befindlichen Federhebel .19 nicht ausschwenken.

Es ist klar erkennbar, daß die Federhebel 19. die Entnahme von sowohl unterschiedlich breiten (b) als auch unterschiedlich langen (1) ICs gestatten. Das längste IC ist durch das Höhenmaß H. bestimmt, das durch die Anzahl der Federhebel 19, einer seitlichen Reihe vorgegeben ist. Dieser Höhenunterschied von IC zu IC ist erheblich groß. Dagegen ist der Breitenunterschied der durchführbaren ICs 14 geringer und durch das Überdeckungsmaß .ü vorgegeben, mit dem die Übergreifkanten 23 die Seitenkanten 24 des betreffenden IC 14 übergreifen. Es ist natürlich auch möglich, andere elektronische Bauelemente durch eine erfindungsgemäß ausgestaltete Entnahmeöffnung 18 zu führen.

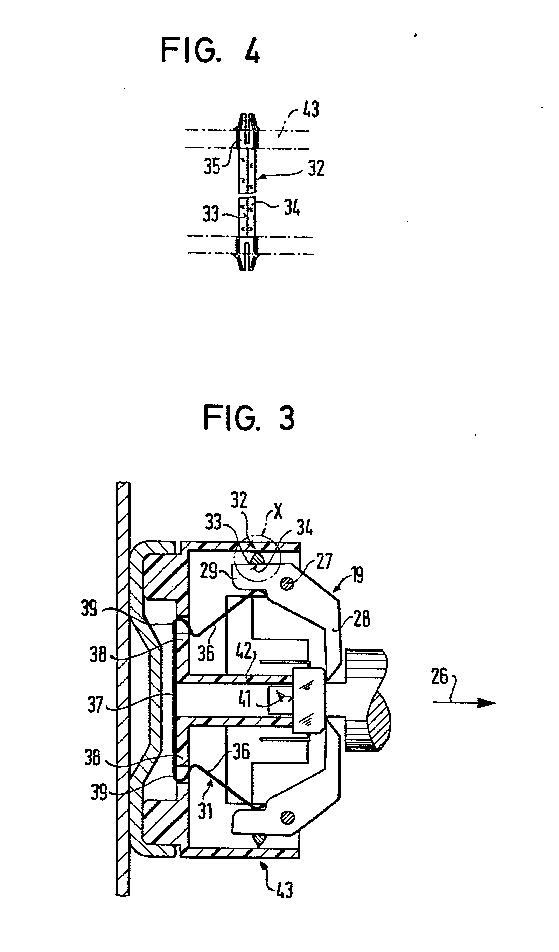

Die Federhebel 19. sind im Einzelnen in der Figur 3 dargestellt. Sie sind jeweils doppelarmig ausgebildet und auf einer Achse 27 gelagert, die sich durch alle Federhebel .19. einer Reihe erstreckt. Der jeweils längere, das IC 14 übergreifende Arm 28, ist krallenförmig gekrümmt. Dem jeweils anderen kürzeren Hebelarm 29. sind eine Rückstellfeder .31 und ein verstellbarer Anschlag 32. zugeordnet. Der Anschlag .32. ist deshalb verstellbar, um die Übergreifkanten (23. der Federhebel .19 an kleinere ICs anpassen zu können.

Bei einer Anschlagverstellung wandern nämlich die Übergreifkanten 23 entweder auf das IC hinzu, oder von diesem hinweg. Als Träger für den durchgehenden und somit für alle Federhebel 19 einer Reihe gleichen Anschlag 32 dient eine Welle 35, die endseitig beispielsweise einen Schlitz für einen Schraubenzieher aufweist, um wahlweise den im Querschnitt dreikantig ausgeführten Anschlag 32 zu verdrehen und somit beispielweise die Ecken 33 oder die Seiten 34 des Anschlags 32 mit dem Hebelarm 29 zusammenwirken zu lassen. Zur Rückstellung von jeweils zwei einander gegenüberliegenden Federhebeln 19 ist eine Blattfeder 35 vorgesehen, die mit ihren freien Schenkeln 36 die Hebelarme 29 vorspannt und in ihrem mittleren Abschnitt 37 durch zwei Rastnasen 38 übergreifende Abwinklungen 39 formschlüssig festgelegt ist.

Aus Figur 3 ist deutlich erkennbar, daß das sich in seiner Entnahmestellung befindliche IC 14 mit seiner Stegunterseite 41 an einem Führungssteg 42 anliegt, was beim noch zu beschreibenden Greifvorgang von Bedeutung ist.

Die im letzteren beschriebenen Bauteile befinden sich mit Ausnahme der Wand 22 an einem Entnahmeendstück 43, dessen in Entnahmerichtung 26 weisende Seite die Entnahmeöffnung 18 darstellt (Fig. 2) Unterseitig ist das Entnahmeendstück 43 durch ein Bodenstück 44 begrenzt, an dem die Wand 22 ausgebildet ist. Oberhalb des Entnahmeendstückes 43 befindet sich ein Adaptergehäuse 45, das zur Aufnahme von gleich ausgebildeten Magazinköpfen 46 dient. Es ist somit möglich, für unterschiedliche Bauelementgrößen oder -arten bestimmte Magazine 2 auszutauschen. Zur Festlegung der Magazinköpfe 46 im Adaptergehäuse 45 dient eine Rastverbindung, die durch eine Rastnase gebildet sein kann, die sich in ihrer Befestigungsstellung in einer Rastausnehmung befindet (nicht dargestellt). Das Lösen einer solchen Rastverbindung erfolgt in einfacher und sehr handlicher Weise durch manuellen Druck auf einen das Adaptergehäuse 45 durchfassenden Zapfen 47, der die Rastnase aus der Rastausnehmung hebt. Nach Lösen der Rastverbindung ist der Magazinkopf 46 nach oben aus dem Adaptergehäuse 45 herausziehbar.

Das Entnahmeendstück 49, das Bodenstück 44 und das Adaptergehäuse 45 sind an einer Befestigungsplatte 48 befestigt, die mittelbar oder unmittelbar am noch zu beschreibenden Depot festgelegt ist.

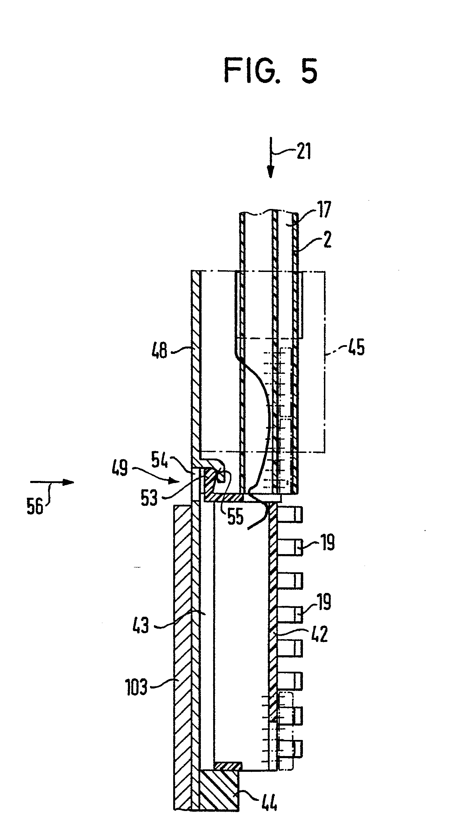

Das Entnahmeendstück 43 ist zum Zweck seiner leichten und schnellen Entnahme bzw.Montage auf die Befestigungsplatte 48 aufklipsbar. Es ist an seinem oberen Ende durch eine in Figur 5 dargestellte und allgemein mit 49 bezeichnete Steckhalterung und an seinem unteren Ende durch Rastnasen 51 gehalten, die beiderseits angeordnet sind, und elastisch auslenkbare Rastnocken 52 hintergreifen (Fig. 2). Die Steckhalterung 49 wird durch einen entgegen der Zuführungsrichtung 21 vom Entnahmeendstück 43 vorspringenden Zapfen 53 gebildet, der in eine an der Befestigungsplatte 48 ausgeformte Tasche 54 einführbar ist. Dabei wirkt der einstückig mit dem Entnahmeendstück 43 aus Kunststoff bestehende Zapfen 53 mit einer bestimmten Vorspannung 56 gegen die Riegelfläche 55 der Tasche 54, so daß das untere Ende des Entnahmeendstückes 43 beim Lösen der allgemein mit 57 bezeichneten Rastverbindung um ein bestimmtes Maß von der Befestigungsplatte 48 abhebt. Dies erleichtert ganz bedeutend die Handhabung. Das Lösen der Rastverbindung 57 erfolgt durch Zusammendrücken entgegen einer nicht dargestellten Federkraft der Rastnocken 52, die an schwenkbar am Bodenstück 44 gelagerten Griffstücken 58 ausgebildet sind. Die Griffstücke 58 sind keilförmig ausgebildet (siehe Figur 2), so daß sie beim Einführen des Entnahmeendstückes 43 automatisch ausweichen und verrasten.

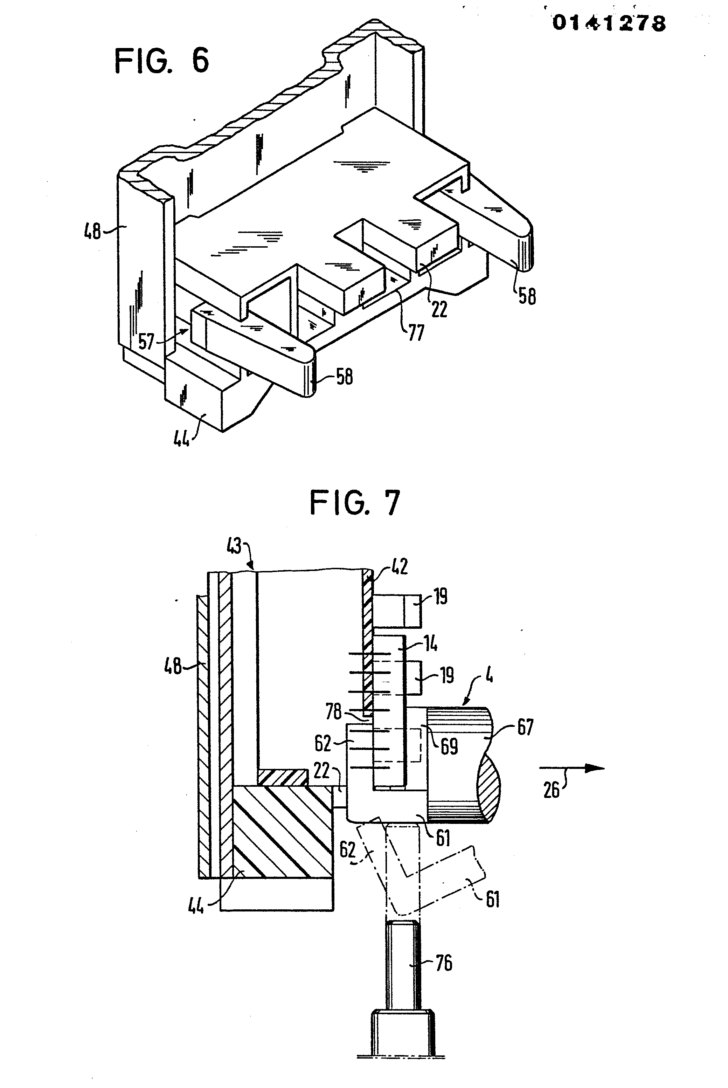

Die in Figur 7 andeutungsweise und in Figur 8 in der Seitenansicht und teilweise im Schnitt dargestellte Greifeinrichtung 4 weist einen sich im wesentlichen entgegen der Entnahmerichtung 26 erstreckenden Greiferfinger 61 auf, der an seinem zur Entnahmeöffnung 18 weisenden Ende einen aufwärts gerichteten Schenkel 62 trägt. Der Greiferfinger ist vertikal schwenkbar um eine Drehachse 63 gelagert und durch eine Feder 64 vorgespannt, die ihn in eine untere Schwenkstellung (in Figur 7 und 8 strichpunktiert dargestellt) zu schwenken sucht, in der der Schenkel 62 unterhalb des zu entnehmenden IC 14 steht. Dabei ist der Greiferfinger 61 in einem Schlitten 65 gehalten, der auf einer durch zwei Säulen 66 gebildeten Führung längs der Entnahmerichtung 26 verschieblich ist und zwar zwischen der in Figur 8 in ausgezogenen Linien dargestellten Greifbereitschaftsstellung oder auch überführungsbereitschaftsstellung und der in strichpunktierten Linien dargestellten Greifstellung des Greiferfingers 61 (siehe auch Figur 7). Innerhalb des Schlittens 65 ist auch noch ein Spannbolzen 67 entlang der Entnahmerichtung 26 beweglich geführt, der durch Druckfedern 68 in Richtung auf den Schenkel 62 des Greiferfingers 61 vorgespannt ist und stirnseitig einen senkrechten schmalen Steg 69 aufweist. Die im Schlitten 65 steckende Achse 63 durchfaßt den Spannbolzen 67 in Langlöchern 71, wodurch zum-einen der Spannbolzen 67 gegen Drehen um seine Längsachse gesichert ist und zum anderen durch die Langlochlänge ein Anschlag gegeben ist, wenn das mit 72 bezeichnete Langlochende gegen die Achse 63 stößt. In dieser Stellung besteht zwischen dem Steg 69 des Spannbolzens 67 und dem Schenkel 62 des Greiferfingers 61 ein Spalt, der kleiner gemessen ist, als die Stegdicke d des kleinsten zu verarbeitenden IC 14. Die vorbeschriebenen Ausgestaltungen ermöglichen die folgend beschriebene Arbeitsweise der Greifeinrichtung 4.

An sich befindet sich die mit Vollinien ausgezogene Greifeinrichtung 4 gemäß Figur 8 in der Überführungsbereitschaftsstellung, weil sie einen IC 14 hält, der zu überführen ist. Wenn der Überführungsvorgang abgelaufen ist, befindet sich die Greifeinrichtung 4 in der gleichen Stellung, d.h. in diesem Falle Greifbereitschaftsstellung ohne ein IC 14. Um ein IC 14 aus der Entnahmeöffnung 18 zu entnehmen, wird der Schlitten 65 mit Hilfe eines nur andeutungsweise dargestellten Antriebs 73 in Richtung des Pfeiles 74 (entgegen der Entnahmerichtung 26) in die strichpunktiert dargestellte Stellung, die Greiferstellung, vorgeschoben. Auf dem Weg in diese Stellung vermag der Greiferfinger 61 herunterzuschwenken, weil er die bei 75 vorhandene Führung verliert, um das bereitstehende IC 14 zu untergreifen. In dieser Position wird das IC 14 durch den Spannbolzen 67 um einen gewissen Betrag gegen den hinter der Entnahmeöffnung 18 befindlichen senkrechten Führungssteg 42 vorgespannt, wodurch der Spannbolzen 67 um diesen Betrag eingeschoben wird. Indieser Greifstellung kann der Greiferfinger 61 unter das IC 14 gesetzt werden, was durch einen in Figur 7 dargestellten Stößel 76 bewerkstelligt wird, der mit Hilfe eines nicht dargestellten Elektromagneten hochgeschoben wird und dabei den Schenkel 62 des Greiferfingers 61 hinter das IC 14 setzt. In der Wand 22 des Bodenstücks 44 und im Führungssteg 42 sind hierfür Ausnehmungen 77 (Figur 6) und 78 (Figur 7) vorgesehen.

Außerdem ist die Distanz zwischen den einander gegenüberliegenden Federhebeln 19 bzw. die Breite b des Stegs 69 so aufeinander abgestimmt, daß dieser zwischen die Federhebel 19 zu fassen vermag.

Aus dieser Position wird der Schlitten 65 zurückgeschoben, wobei der Greiferfinger 61 aufgrund der Spannung, mit der der Spannbolzen 67 den ergriffenen IC 14 gegen den Schenkel 62 drückt, in dieser oberen Schwenkstellung gehalten. Diese Halterung wird durch die bei 75 vorhandene Führung in der Übertragungsbereitschaftsstellung ersetzt. Das Zurückschieben erfolgt durch zwei Zugfedern 79.

Wie eingangs schon beschrieben, überträgt die Übertragungsvorrichtung 5 das entnommene IC 14 in eine Position oberhalb der Stecköffnung 8, wie in Figuren 9 und 1o dargestellt. Anschließend wird die Greifeinrichtung 4 durch den auch hier vereinfacht dargestellten Antrieb 73 in die in Figur 11 dargestellte Position durch die Stecköffnung 8 hindurch heruntergeschoben und mit der schon beschriebenen gewissen Vorspannung durch den Spannbolzen 67 gegen ein Aufnahmestück 87 der Griffschale 13 gedrückt. Sobald diese vorbeschriebene Vorspannung wirkt, schwenkt der Greiferfinger 61 automatisch aus seiner Hinterfassungsstellung zurück, so daß die Greifeinrichtung 4 wieder zurückgeschoben (Fig. 9) und dann in ihre Greifbereitschaftsstellung zurückgeschwenkt bzw. zurückgedreht werden kann.

Die Übertragungsvorrichtung 5 besteht aus einer drehbar in einer auf dem Bestückungstisch 1 aufliegenden exzentrischen Platte 81 gelagerten Welle 82, mit Zahnrad 80, zwei in seitlichen Abflachungen 83 der Welle 82 verschraubten und sich quer zur Welle 82 erstreckenden Wangenstücken 84, einer zwischen und längs zu den Wangenstücken geführten Zahnstange 85, einem am freien Ende der Wangenstücke auf einer Achse 86 gelagerten und mit der Zahnstange 85 kämmenden Zahnrads 87 und einem auf der seitlich aus den Wangenstücken 84 hinausragenden Achse 86 befestigten Schlittenhalter 88, wobei zwischen diesem und den Wangenstücken 84 eine Drehfeder 89 eingesetzt und zwischen der Zahnstange 85 und der exzentrischen Platte 81 ein Laufrad 91 eingeschaltet ist, das auf einer starr von der Zahnstange 85 ausgehenden Achse 92 sitzt (Fig. 12).

Die Führung für die Zahnstange 85 wird durch am besten in Figur 10 erkennbaren Führungsplatten 93 gebildet, die unter die Wangenstücke 84 geschraubt sind und in Längsnuten 94 der Zahnstange 85 fassen.

Für einen Übertragungsvorgang aus der in Figur 1 ersichtlichen Stellung der Übertragungsvorrichtung 5 wird die Welle 82 durch einen Antrieb 95 mittels eines Zahnriemens 96 im Uhrzeigersinn angetrieben. Dabei wird die Greifeinrichtung 4 im Uhrzeigersinn parallel zum Bestückungstisch 1 geschwenkt und gleichzeitig um die Achse 86 in die Stellung gemäß Figur 10 geschwenkt. Dabei wird die Zahnstange 85 entsprechend der exzentrischen Kontur 97 der Platte 81 gemäß Figur 12 nach rechts verschoben. Die Drehfeder 89 sorgt dafür, daß beim Zurückfahren der Übertragungsvorrichtung 5 aus der Position gemäß Figur 10 in die Ausgangsposition gemäß Figur 1 das Laufrad 91 der Kontur 97 der exzentrischen Platte 81 folgt und der Schlittenhalter 88 gegen die exzentrische Platte 81 vorgespannt ist.

Das in Figur 1 allgemein mit 3 bezeichnete Depot besteht aus einer in einer zum Bestückungstisch 1 parallelen Ebene drehbaren Drehscheibe 1o1 und einer seitlich in einem Abstand davon in der gleichen Drehebene drehbar gelagerte Scheibe 1o2, um die ein Transportband 1o3 läuft, das die Magazine 2 trägt. Zwischen wenigstens der angetriebenen Drehscheibe 1o1 und dem Transportband 1o3 besteht ein formschlüssiger Antrieb, so daß eine relative Verschiebung zwischen diesen Teilen ausgeschlossen ist.

Die Figur 14 zeigt ein Ausführungsbeispiel eines in Fig. 2 ersichtlichen Kopfes 46 zur Halterung des Magazins 2 im Gehäuse 45.

Der in Fig. 14 mit 1o5 bezeichnete Kopf besteht aus einem das Magazin 2 umgreifenden Halter 1o6 mit zwei Paar Halterungsarmen 1o7,1o8, die sich in die Ecken des Gehäuses 45 hinein erstrecken. Während das Paar 1o7 sich parallel zu den Seiten 1o9 des Gehäuses 45 erstreckt, sind das Paar 1o8 rechtwinklig zu dem Paar 1o7, also parallel an den Seiten 11o ausgerichtet, wobei sie auseinanderstreben. Deshalb federn die Paare der Halterungsarme 1o7,1o8 beim Einsetzen in das Gehäuse in rechtwinklig zueinander gerichteten Richtungen aus, weshalb auch die Richtungen der Spannungen zur elastischen Halterung rechtwinklig zueinander gerichtet sind.

Im Bereich der Profileinziehung 111 ist der Halter 1o6 ausgespart um Platz für dem Magazin 2 zugeordnete Verschlußteile zu schaffen.

An den Halterungsarmen 1o6 endseitig angeordnete Vorsprünge 112 stellen Anschläge dar und begrenzen die Einschubtiefe des Halters 1o6 im Gehäuse 45. Die Befestigung des Halters 1o6 auf dem Magazin kann in vorteilhafter Weise durch Kleben oder dergleichen oder strammen Sitz erfolgen.

Entgegen dem vorbeschriebenen Ausführungsbeispiel ist es im Rahmen der Erfindung auch möglich, den Halter unmittelbar in das Gehäuse einzusetzen und die Halterungsarme sich nach innen gegen das Magazin 2 erstrecken zu lassen.

0141278

PATENTANSPRÜCHE

1) Vorrichtung zum Übertragen von elektronischen
Bauelementen, insbesondere IC's, von einem Depot,
in dem eine Vielzahl der Bauelemente in einer Reihe
aufeinanderfolgend angeordnet sind, zu einem Verwertungsort, mit einem Greifkopf für die Bauelemente, welcher
zwischen einer Entnahmeöffnung an dem Depot und dem
Verwertungsort bewegbar ist, dadurch gekennzeichnet, daß
das jeweils in der Entnahmeöffnung (18) befindliche Bauelement (6,14) durch mindestens ein Halteteil (Federhebel 19) gehalten ist, welches bei der Entnahme eines
Bauelementes (6,14) elastisch auslenkbar ist.

2) Vorrichtung nach Anspruch 1,
dadurch gekennzeichnet,
daß zu beiden Seiten der Entnahmeöffnung (18) ein Halteteil (19) vorgesehen ist.

3) Vorrichtung nach Anspruch 1 oder 2,
dadurch gekennzeichnet, daß das oder die Halteteile (19) durch bevorzugt plattenförmige Lamellen-gebildet sind, die an ihren der Entnahmeöffnung (18) abgewandten Endbereichen gehalten sind.

4) Vorrichtung nach einem der Ansprüche 1 bis 3, dadurch gekennzeichnet, daß-längs einer Seite der Entnahmeöffnung (18) gesehen - mehrere Halteteile (19) hintereinander angeordnet sind.

5) Vorrichtung nach Anspruch 4, dadurch gekennzeichnet, daß wenigstens die auf einer Seite der Entnahmeöffnung (18) angeordneten Halteteile (19) gleich ausgebildet sind.

6) Vorrichtung nach einem der Ansprüche 4 oder 5, dadurch gekennzeichnet, daß der gesamte Höhenbereich (H) der Entnahmeöffnung (18) mit Halteteilen (19) besetzt ist.

7) Vorrichtung nach einem der Ansprüche 1 bis 6, dadurch gekennzeichnet, daß das oder die Halteteile (19) durch einen schwenkbar gelagerten Hebelarm gebildet sind, der durch eine Feder (Rückstellfeder 31) in Richtung auf seine Normalstellung beaufschlagt ist.

8) Vorrichtung nach einem der Ansprüche 4 bis 7, dadurch gekennzeichnet, daß alle Halteteile (Federhebel 19) einer Entnahmeöffnungsseite von einer durchgehenden Schwenkachse (27) durchfaßt sind.

9) Vorrichtung nach Anspruch 8,
dadurch gekennzeichnet,
daß das oder die Halteteile (19) durch doppelarmige
Hebelarme gebildet sind, an deren dem IC abgewandten
Hebelarmen (29) die Federn (31) angreifen.

1o) Vorrichtung nach einem der Ansprüche 2 bis 9,
dadurch gekennzeichnet,
daß für zwei einander gegenüberliegende Halteteile (19)
eine bevorzugt blattförmige Feder (31) vorgesehen ist,
die in ihrem mittleren Bereich (37) bevorzugt formschlüssig gehalten und mit ihren freien Enden (36) auf
die Halteteile (19) wirkt.

11) Vorrichtung nach einem der Ansprüche 7 bis 1o,
dadurch gekennzeichnet,
daß die Halteteile (19) krallenförmig mit entgegen der
Entnahmerichtung (26) gerichteten Halteteilabschnitten
ausgebildet sind, wobei die Schwenkachsen (27) im
Bereich dieser Halteteilabschnitte angeordnet sind.

12) Vorrichtung nach einem der Ansprüche 1 bis 11,
dadurch gekennzeichnet,
daß die Normalstellung des Halteteils oder der Halteteile (19) durch verstellbare Anschläge (32) einstellbar ist.

13) Vorrichtung nach Anspruch 12,
dadurch gekennzeichnet,
daß die Anschläge (32) an einer für alle Halteteile einer
Entnahmeöffnungsseite gemeinsamen Nocken- oder
Exzenterwelle (35) ausgebildet sind, die bevorzugt endseitig für einen Werzeugeingriff zwecks Drehens
um ihre Achse eingerichtet ist.

14) Vorrichtung nach einem der Ansprüche 1 bis 13,
dadurch gekennzeichnet,-.
daß die Entnahmeöffnung (18) und das bzw. die Halteteile
(19) einem Entnahmeendstück (43) zugeordnet sind, das bevorzugt formschlüssig und in Flucht mit dem Zuführungskanal (17) am mittel- oder unmittelbaren Depot (3) festlegbar ist.

15) Vorrichtung nach Anspruch 14, dadurch gekennzeichnet,
daß das Entnahmeendstück .(43) aufklipsbar ist.

16) Vorrichtung nach Anspruch 14 oder 15, wobei der Zuführungskanal etwa vertikal verläuft und die Bauelemente
der Entnahmeöffnung in einer Position zugeführt werden,
in der ihre durch die Anschlußfahnen vorgegebenen U-Form
sich in Zuführungsrichtung erstreckt,
dadurch gekennzeichnet,
daß das Entnahmeendstück (43) an seinem untere Ende aufklipsbar und an seinem oberen Ende durch formschlüssigen
Eingriff (49) bevorzugt entgegen der Zuführungsrichtung
(21) festlegbar ist.

17) Vorrichtung nach Anspruch 16,
dadurch gekennzeichnet,
daß die Formschlußverbindung (49) eine sich etwa längs der
Zuführungsrichtung (21) erstreckende Riegelfläche insbesondere einen sich entgegen der Zuführungsrichtung (21) erstreckenden Vorsprung (53) am Entnahmeendstück (43) umfaßt, mit dem das Entnahmeendstück (43) entgegen der Zuführungsrichtung (21) unter ein sich etwa längs der Zuführungsrichtung erstreckendes Riegelstück Riegelfläche
(55) am Depot (3) oder Magazin (2) schiebbar ist.

18) Vorrichtung nach einem der Ansprüche 14 bis 17,
dadurch gekennzeichnet,
daß das Entnahmeendstück (43) als Verlängerung der Führung
für die Bauelemente im Magazin (2) von den Anschlußfahnen
(16) der Bauelemente (6,14) umgreifbaren Führungstyp (42)
aufweist, der sich etwa über den gesamten Entnahmeöffnung (18) erstreckt.

19) Vorrichtung nach einem der Ansprüche 1 bis 18,
dadurch gekennzeichnet,
daß die Entnahmeöffnung (18) an der in Zuführungsrichtung (21) weisenden Seite durch ein Wandteil (22) eines
Bodenstücks (44) begrenzt ist, wobei das Bodenstück (44)
starr an dem Depot (3) bzw. Magazin (2) befestigt ist.

2o) Vorrichtung nacheinem der Ansprüche 15 bis 19,
dadurch gekennzeichnet,
daß am Entnahmeendstück (43) oder bevorzugt am Bodenstück
(44) wenigstens eine entgegen einer Vorspannungskraft
ausweichbare Verrastungsnase (52) angeordnet ist, die von
einem am jeweils anderen Teil angeordneten Verrastungsnocken (57) beim Aufsetzen des Entnahmeendstückes (43)
überfahrbar ist.

21) Vorrichtung nach Anspruch 2o,
dadurch gekennzeichnet,
daß zu beiden Seiten Verrastungsnasen (52) mit in Entnahmerichtung (21) vorspringenden Griffstücken (58)
angeordnet sind, deren Vorspannungskräfte jeweils voneinander weg gerichtet sind.

22) Vorrichtung nach einem der Ansprüche 17 bis 2o,
dadurch gekennzeichnet,
daß der Vorsprung (53) des Entnahmeendstückes mit einer
solchen quer zur Zuführungsrichtung (21) gerichteten
Vorspannung in die Formschlußverbindung (49) faßt,
daß das untere Ende des Entnahmeendstückes (43) nach dem
Lösen seiner Verrastung automatisch von seiner Auflage
abhebt.

23) Vorrichtung insbesondere nach einem der Ansprüche 1 bis 22,
wobei der Greifkopf in Richtung auf das Depot und
zurück in einer Führung beweglich ist,
dadurch gekennzeichnet, daß der Greifkopf (4) einen winkelförmigen Greiferfinger (61) aufweist, der quer zur Entnahmerichtung (26) verstellbar und entgegen der Zuführungsrichtung (21) derart hinter das Bauelement (6,14) setzbar ist, daß sein in Greifposition quer zur Entnahmerichtung (26) sich erstreckender Schenkel (62) die innere Stegseite des Bauelements (6,14) umfaßt.

24) Vorrichtung nach Anspruch 23, dadurch gekennzeichnet, daß dem Greifkopf (4) ein längs der Entnahmerichtung (26) hin- und herbeweglicher Spannbolzen (67) zugeordnet ist, der das Bauelement (6,14) in der Greifposition gegen dessen Führung (Führungsteg 42) und beim Zurückschieben der Greifeinrichtung (4) gegen den Schenkel (62) zu spannen vermag.

25) Vorrichtung nach Anspruch 24, dadurch gekennzeichnet, daß der Spannbolzen (67) durch wenigstens eine Feder (68) vorgespannt ist.

26) Vorrichtung nach Anspruch 24 und 25, dadurch gekennzeichnet, daß der Spannbolzen (67) verdrehungssicher gelagert ist und stirnseitig einen schmalen, sich parallel zur Zuführungsrichtung (21) erstreckenden Steg (69) aufweist.

27) Vorrichtung nach einem der Ansprüche 23 bis 26, dadurch gekennzeichnet, daß der Greiferfinger (61) um eine quer zur Entnahmerichtung (26) verlaufende Schwenkachse (63) schwenkbar an der Greifeinrichtung (4) gelagert ist.

28) Vorrichtung nach einem der Ansprüche 23 bis 27 dadurch gekennzeichnet,
daß der Greiferfinger (61) derart hakenförmig geformt ist, daß die Schwenkachse (63) auf einer Mittelsenkrechten des Schenkels (62) liegt.

29) Vorrichtung nach Anspruch 23 bis 28, dadurch gekennzeichnet,
daß der Greiferfinger (61) durch eine Feder (64) in seine Offenstellung beaufschlagt ist.

3o) Vorrichtung nach einem der Ansprüche 23 bis 29, dadurch gekennzeichnet,
daß der Greiferfinger (61) durch einen bevorzugt in dessen Schwenkebene verschiebbaren Stößel (76) in seine das Bauelement (6,14) hinterfassende Stellung schwenkbar ist.

31) Vorrichtung nach Anspruch 3o, dadurch gekennzeichnet,
daß der Stößel (76) durch einen Elektromagneten verschiebbar ist, der einschaltbar ist, wenn der Greifkopf (4) in seine Entnahmeposition (Fig. 7) vorgeschoben worden ist.

32) Vorrichtung nach dem Oberbegriff des Anspruches 1, wobei die Übertragungsvorrichtung dem Greifkopf um eine parallel zu ihrer Basis verlaufende Schwenkachse sowie in einer zu ihrer Basis parallelen Ebene schwenkt, dadurch gekennzeichnet,
daß die Übertragungsvorrichtung (5) durch eine sich etwa senkrecht zu ihrer Basis (Bestückungstisch 1)erstreckende, durch einen Antrieb (95,96) drehbaren Antriebswelle (82) gebildet ist, an der ein sich quer erstreckender Ausleger (Wangenstück 84) starr befestigt ist, an dessem freien Ende eine sich etwa parallel zur Basis erstreckende Antriebswelle (86) gelagert ist, die auf einem aus dem Ausleger (84) herausragenden Abschnitt den Greifkopf (4) trägt und auf der im Bereich des Auslegers (84) ein Zahnrad (87) befestigt ist, das mit einer im oder am Ausleger (84) längs beweglich geführten Zahnstange (85) kämmt, die durch den Abgriff einer exzentrisch zur Drehachse der Antriebswelle angeordneten Kurvenbahn (97) verschiebbar und mittels einer Federkraft (Drehfeder · 89) mittelbar oder unmittelbar in Richtung auf die Kurvenbahn (97) beaufschlagt ist.

33) Vorrichtung nach Anspruch 32,
dadurch gekennzeichnet,
daß die Kurvenbahn (97) an einer starr auf der Basis (1) befestigten Exzenterscheibe (81) ausgebildet ist, die bevorzugt die Antriebswelle (82) lagert.

34) Vorrichtung nach Anspruch 32 oder 33,
dadurch gekennzeichnet,
daß zum Abgreifen der Kurvenbahn (97) ein Rad (91) vorgesehen ist, das auf einer mittelbar oder unmittelbar an der Zahnstange (85) befestigten Achse (92) drehbar gelagert ist.

35) Vorrichtung nach Anspruch 34,
dadurch gekennzeichnet,
daß der Ausleger durch zwei Platten (84) gebildet ist, die bevorzugt in Abflachungen (83) der Antriebswelle (82) beispielsweise durch Schrauben befestigt sind und die Zahnstange (85) und das Zahnrad (87) zwischen sich einschließen.

36) Vorrichtung nach einem der Ansprüche 1 bis 37,
dadurch gekennzeichnet,
daß der Greifkopf (4) zu seiner Verschiebung in Richtung auf das Depot (3) und zurück auf zwei Führungssäulen (66) verschiebbar-ist.

37) Vorrichtung nach Anspruch 36,
dadurch gekennzeichnet,
daß die Führungssäulen (66) in den Stegen eines U-
förmigen Schlittenhalters (88) befestigt sind, der
starr an der Abtriebswelle (86) befestigt ist.

38) Bestückungstisch nach einem der Ansprüche 32 bis 37,
dadurch gekennzeichnet,
daß auf der Antriebswelle (82) ein Antriebsrad (80)
befestigt ist, das durch einen formschlüssigen Antrieb,
insbesondere durch einen Zahnriementrieb, mit einem
Antrieb (95) in Verbindung steht.

39) Bestückungstisch, insbesondere nach einem der
Ansprüche 1 bis 38, wobei das Depot eine antreibbare
Drehscheibe umfaßt, an deren Umfang eine Mehrzahl von
Magazinen angeordnet sind, die jeweils durch begrenzte
Drehbewegungen der Drehscheibe wenigstens einer
Entnahmestelle zuführbar sind,
dadurch gekennzeichnet,
daß die Magazine (2) an der Außenseite eines endlosen
Bandes oder Kette (103) angeordnet sind, das bzw. die
die Drehscheibe (101) und eine weitere Drehscheibe (102)
umspannt, die in der gleichen Ebene um eine parallele
Drehachse drehbar ist, wobei das Band bzw. die Kette
(103) in formschlüssiger Antriebsverbindung mit der antreibbaren Drehscheibe (101) steht.

40) Vorrichtung nach einem der Ansprüche 1 bis 39,
dadurch gekennzeichnet,
daß sie bei einem Bestückungstisch (1) für Leiterplatten
(7) verwendet ist, wobei der Verwertungsort (Abgabestelle 12) eine Griffschale (8) einer Schalenkette
oder dergleichen ist, von denen jede mit Bauelementen
bestimmter Art befüllt wird und wobei das Depot (3)
aus mehreren an dem Greifkopf (4) vorbeibewegbaren
Magazinen (2) besteht, die ihrerseits mit Bauelementen
(6,ICs,14) bestimmter Art gefüllt sind.

41) Vorrichtung insbesondere nach einem der Ansprüche
1 bis 4o,
dadurch gekennzeichnet,
daß am Depot (3) bevorzugt beim Vorhandensein eines Entnahmeendstückes (43) oberhalb desselben ein Adapter
(45) für unterschiedliche Bauelemente (6,14) enthaltende und einander gleiche Anschlüsse aufweisende
Magazine (2) vorgesehen ist.

42) Vorrichtung nach Anspruch 41,
dadurch gekennzeichnet,
daß der Adapter ein Gehäuse (45) bevorzugt viereckigem
Querschnitt aufweist, in das von oben das jeweilige
Magazin (2) einschiebbar ist, wobei vorzugsweise
eine Rastausnehmung vorgesehen ist, in die
eine beispielsweise durch Fingerdruck lösbare Rastnase des Kopfes in eingesetzter Position des Magazins
verrastbar ist.

43) Vorrichtung nach Anspruch 41 oder 42,
dadurch gekennzeichnet,
daß der Adapter (45) und das Entnahmeendstück (43)
an einer gemeinsamen Befestigungsplatte (48) gehalten
sind, die am Depot (3) festgelegt ist.

44) Vorrichtung nach Anspruch 42,
dadurch gekennzeichnet,
daß zur Aufnahme des Magazins (2) im Gehäuse (45) ein
im Gehäuse (45) oder bevorzugt am Magazin (2) fixierter
Kopf (46,1o5) vorgesehen ist, der in das Gehäuse (45)
schließend einfaßt oder das Magazin schließend umgreift.

45) Vorrichtung nach Anspruch 44,
dadurch gekennzeichnet,
daß der Kopf (46,1o5) aus elastischem Kunststoff oder
Gummi besteht.

46) Vorrichtung nach Anspruch 44 oder 45,
dadurch gekennzeichnet,
daß der Kopf (1o5) einen rahmenförmigen im Bereich
der Profileinziehung (111) des Magazins (2) ausgesparten Halter (1o6) aufweist, von dem sich sternförmig Halterungsarme (1o7,1o8) erstrecken (entweder
einwärts oder auswärts).

47) Vorrichtung nach Anspruch 46,
dadurch gekennzeichnet,
daß zwei Paar Halterungsarme (1o7,1o8) am Magazin
(2) fixierten Halter vorgesehen sind, die sich in die
Ecken des Gehäuses (45) erstrecken, wobei die Halterungsarme (1o7) eines Paares etwa parallel und die (1o8)
des anderen Paares sich etwa rechtwinklig zu den ersteren
und einander entgegengesetzt erstrecken.

0141278

# FIG. 1

0141278

FIG. 2

# FIG. 4

# FIG. 3

# FIG. 5

0141278

## FIG. 6

## FIG. 7

# FIG. 8

# FIG. 9

# FIG. 10

# FIG. 11

## FIG. 12

## FIG. 13

# FIG. 14